# EUROPÄISCHE PATENTSCHRIFT

(11) **EP 0 750 597 B1**
(45) Veröffentlichungstag und Bekanntmachung des Hinweises auf die Patenterteilung: **18.08.1999**
(21) Anmeldenummer: 95936979.4
(22) Anmeldetag: 25.11.1995
(51) Int. Cl.: C04B 35/622, B32B 18/00, H01L 21/48, H01L 23/15

(54) **VERFAHREN ZUR HERSTELLUNG VON KERAMISCHEN VERBUNDKÖRPERN**
METHOD OF PRODUCING CERAMIC COMPOSITE BODIES
PROCEDE DE PRODUCTION DE CORPS COMPOSITES CERAMIQUES

(30) Priorität: 24.12.1994 DE 4446533
(43) Veröffentlichungstag der Anmeldung: 02.01.1997
(73) Patentinhaber: ROBERT BOSCH GMBH, 70442 Stuttgart (DE)
(72) Erfinder: LINDEMANN, Gert, D-72805 Lichtenstein (DE); SCHNEIDER, Gerhard, D-71665 Vaihingen (DE); STARK, Elisabeth, D-70839 Gerlingen (DE); HOLZSCHUH, Ralph, 75233 Tiefenbronn (DE)
(86) Internationale Anmeldenummer: DE9501662
(87) Internationale Veröffentlichungsnummer: WO9620145

(56) Entgegenhaltungen:
- EP-A- 0 383 391
- EP-A- 0 406 911
- EP-A- 0 615 964
- WO-A-92/13435

## Beschreibung

### Stand der Technik

Keramische, aus mindestens zwei Schichten bestehende Verbundkörper sind u.a. von Bedeutung für elektrische oder elektronische Bauteile oder Funktionselemente, die auf einem keramischen Substrat aufgebaut sind und zumeist mehrere, durch Zusammensintern miteinander bzw. mit dem Substrat verbundene keramische Funktionsschichten enthalten. Unter "keramisch" wird hier und im folgenden verstanden, daß die Schichten im wesentlichen aus harten oxidischen anorganischen Materialien, Carbiden, Nitriden und/oder Boriden bestehen. Daneben enthalten keramische Substrate und Funktionsschichten in der Regel in untergeordnetem Maße Kohlenstoff und gegebenenfalls andere Elemente, wie Stickstoff, als Überbleibsel von organischen Verbindungen, die bei ihrer Herstellung verwendet wurden. Elektrische Bauteile oder Funktionselemente der genannten Art sind z.B. keramische Kondensatoren, Varistoren, NTC- bzw. PTC-Widerstände, Aktuatoren und Resonatoren. In der Elektronik gehören Schaltkreise, die in Dick- und Dünnschichttechnik auf keramische Chip-Träger, z.B. Al₂O₃-Substrate, aufgebracht wurden, als Bauteile und Funktionselemente zum Stand der Technik. Weiterhin sind in jüngerer Zeit Sensorelemente, wie planare physikalisch-chemische Sensoren mit Schichten aus oxidischen Festelektrolyten (durch Y₂O₃ stabilisiertes ZrO₂) zur Messung der Sauerstoffkonzentration in Gasen oder mit anderen gas-sensitiven Schichten, entwickelt worden, die in Folien- bzw. Dickschichttechnik mit anschließendem Cofiring, d.h. gemeinsamem Sintern von Substrat und Funktionsschicht(en), hergestellt werden. Diese Entwicklungen haben auch auf dem Gebiet der mechanischen Sensor- oder Aktuatorelemente auf Basis von ferromagnetischen bzw. piezoelektrischen Werkstoffen sowie auf dem Gebiet der Energietechnik bei Hochtemperaturbrennstoffzellen auf Basis von oxidischen Festelektrolyten Eingang gefunden.

Allen genannten Entwicklungen gemeinsam ist, daß sie von flexiblen Folien aus dem entsprechenden Basiswerkstoff ausgehen, die nach dem Cofiring das Substrat bilden und auf die vorher in Dickschichttechnik, z. B. nach dem Siebdruckverfahren, Schichten aus keramischen Schlickern aufgetragen wurden, die nach dem Co-firing die jeweiligen Funktionsschichten ergeben, z. B. Isolierschichten, interlaminare Binderschichten, Elektroden oder Widerstandselemente, wie Heizer. Die flexiblen Folien können beispielsweise durch Gießen von Schlickern nach dem Doctorblade-Verfahren hergestellt werden (siehe Mistler, R. E. Shanefield, D. J. und Runk, R. B. "Tape Casting of Ceramics", Seiten 411-448 in "Ceramic Processing Before Firing", herausgegeben 1978 von G. Y. Onada und L.L. Hench, Verlag John Wiley and Sons, Inc., New York, Chichester Brisbane und Toronto). Dabei wird ein keramischer Schlicker, der das keramische Rohstoffpulver, Lösungsmittel und Folienbildner, d. h. Bindemittel und Weichmacher, enthält, mit einem oder mehreren verstellbaren Rakeln (oder Messern) auf einer ebenen Unterlage zu einer Folie ausgestrichen, die anschließend durch Abdampfen des Lösungsmittels trocknet. Nach dem Ablösen von der ebenen Unterlage werden aus der Folie Substratkarten gestanzt.

In der WO-92/13435 ist beispielsweise ein Verfahren zur Herstellung von keramischen Verbundkörpern beschrieben, wobei auf eine Kunststoffträgerfolie aus beispielsweise Polyamid oder Polyphenylensulfid eine Paste aus einer Mischung eines keramischen Pulvers, eines Sinterhilfsmittels, eines organischen Binders, eines Weichmachers und eines Lösungsmittels in Form einer Folie einheitlicher Dicke aufgetragen und getrocknet wird, um einen Grünkörper zu formen. Auf diesen Grünkörper kann dann eine Strukturierung in Form von elektrischen Schaltkreisen und Leiterbahnen vorgenommen werden. Danach wird die Grünkörperfolie von der Kunststoffträgerfolie entfernt und mit mindestens einer weiteren Grünkörperfolie laminiert und zusammengesintert. Die Kunststoffträgerfolie weist dabei eine niedrige Glasübergangstemperatur und eine hohe Beständigkeit gegenüber organischen Lösungsmitteln als auch gegen Luftfeuchtigkeit auf.

Bei der Herstellung von vielschichtigen Bauteilen oder Funktionselementen ist es in der Regel erforderlich, die Substratfolien beidseitig mit Schichten zu bedrucken, die nach dem Cofiring zu Funktionssichten werden. Ein wichtiges Erfordernis für fehlerfrei arbeitende Bauteile oder Funktionselemente ist einerseits eine hohe mechanische Stabilität, d. h. eine feste Verbindung der Funktionsschichten untereinander und mit dem Substrat. Ein anderes Erfordernis ist eine gleichmäßige Qualität, der Funktionsschichten, d. h. ein homogenes Eigenschaftsbild innerhalb der gesamten Funktionsschicht. Für beide Erfordernisse spielt die Rauhigkeit der Oberfläche der Substratfolie eine Rolle. Ist die Oberfläche zu glatt, so beeinträchtigt dies eine gute Verzahnung und damit die feste Verbindung der Schichten zunächst der "Grünkörper", wie die noch organische Bestandteile enthaltenden Verbundkörper vor dem Sintern genannt werden. Diese sind dann nur mit Vorsicht handhabbar. Eine zu glatte Oberfläche der Substratfolie beeinträchtigt aber auch die feste Verbindung der entsprechenden Schichten in dem gesinterten keramischen Verbundkörper, so daß die Bauteile oder Funktionselemente mechanisch nicht genügend beanspruchbar sind. Ist die Rauhigkeit zu groß, so treten Inhomogenitäten in den Funktionsschichten um so eher auf, je mehr deren Stärke sich den Größenordnungen annähert, die für die Rauhigkeit von Folienoberflächen kennzeichnend sind. Wegen der speziellen Anforderungen ist die Charakterisierung der Substratfolien durch nur eine Kenngröße, wie die gemittelte Rauhtiefe R_{z} nach DIN 4768, nicht hinreichend. Es müssen vielmehr weitere Rauhigkeitskenngrößen herangezogen werden, wie die maximale Rauhtiefe Rₐ nach DIN 4776 und die Tiefe des ungefilterten Profils Pₜ nach DIN 4771. Um eine gute Haftung und zugleich eine gute Homogenität der Funktionsschichten zu erreichen, darf die mittlere Rauhtiefe nicht zu gering sein, die maximale Rauhtiefe und die Profiltiefe dürfen hingegen bestimmte Werte nicht übersteigen. Rauhigkeitswerte R_{z} = 2-10µm, insbesondere 2-6µm; Rₐ <10µm, insbesondere <7µm; und Pₜ <15µm, insbesondere <10µm, haben sich als vorteilhaft erwiesen.

Diese Kriterien für die Oberflächenrauhigkeit gelten für beide Seiten (Ober- und Unterseite) der Substratfolien. Die Rauhigkeit der Oberseite wird durch die Größe und die Größenverteilung der Feststoffpartikel maßgeblich beeinflußt. Typische Werte liegen hier bei R_{z}=2-3µm, Rₐ=2-4µm bzw. Pₜ=5-10µm. Auf der Gießunterseite ist dagegen die Beschaffenheit der Gießunterlage, d.h. im allgemeinen der Trägerfolie, von entscheidender Bedeutung für die Rauhigkeit der getrockneten Substratfolien. Um den Anforderungen zu entsprechen, muß die Gießunterlage absolut eben und frei sein von anhaftenden Verunreinigungen, wie Staubpartikel, anhaftende Materialien usw., sowie von mechanischen Schädigungen, wie Riefen, Kratzern und Poren. Solche Verunreinigungen und Schädigungen würden sich sonst in der Unterseite der Substratfolien abbilden und könnten nach dem Co-firing zu Fehlstellen in den Funktionsschichten führen, z.B. zu Inhomogenitäten in der Schichtdicke und damit im Widerstand von Elektroden, zu Kurzschlüssen durch Isolationsschichten hindurch usw. Der keramische Schlicker muß einerseits alle Unebenheiten und Vertiefungen in der Oberfläche der Gießunterlage ausfüllen. Andererseits muß eine zu starke adhäsive Wechselwirkung insbesondere der im keramischen Schlicker enthaltenen organischen Bindemittel mit der Gießunterlage verhindert werden, da anderenfalls die Trockenschwindung beeinträchtigt wird, was ein Verziehen der keramischen Folie bewirken kann.

In der Praxis wird der keramische Schlicker auf ein umlaufendes Stahlband gegossen. Zur Vermeidung von unerwünschten Adhäsionseffekten werden Trennmittel verwendet, häufig siliconhaltige Lösungen, die auf das Stahlband aufgetragen werden und nach dem Trocknen einen dünnen Siliconfilm bilden. Vielfach werden auch mit Silicon beschichtete Kunststoffträgerfolien verwendet, die von dem Stahlband mitgeführt werden. Damit beim Schwinden infolge der Trocknung des keramischen Schlickers kein Verzug der keramischen Folie eintritt, müssen die Kunststoffträgerfolien entsprechend stabil und verwindungssteif sein. Diese Voraussetzungen erfüllen z.B. Polyesterfolien von entsprechender Stärke. Mit Silicon beschichtete Polyesterfolien haben jedoch ein hohes elektrostatisches Potential, weshalb leicht Fremdpartikel, wie Staub- und Faserteilchen usw., angezogen werden, die sich auf der Oberfläche festsetzen und beim Auftragen des keramischen Schlickers eingeschlossen werden.

Trennmittelschichten, z.B. aus Silicon, erweisen sich häufig auch deshalb als kritisch, da sie sich beim Schwinden des zu einer Folie trocknenden keramischen Schlickers von der Trägerfolie teilweise ablösen und manchmal bereits nach einem Zyklus erneuert werden müssen. Neben einem wirtschaftlichen bedeutet dies vor allem einen erheblichen technischen Nachteil. Für die Haftung der benachbarten Funktionsschicht, die aus dem später aufgebrachten zweiten keramischen Schlicker entsteht, ist es wichtig, daß beim Aufbringen dieses Schlikkers die Oberfläche der keramischen Folie in gewissem Maße angelöst wird. Dieses Anlösen wird durch auf der Oberfläche der keramischen Folie anhaftendes Trennmittel erheblich vermindert. Zum Teil lösen sich die aufgebrachten Schichten des keramischen Schlickers bereits nach dem Trocknen wieder von dem Substrat ab.

Weiterhin sind durch Naßauftragsverfahren aufgebrachte Trennmittelschichten nicht zuverlässig frei von oberflächlichen Reliefstrukturen, die vom jeweiligen Auftragsverfahren (mit Pinsel, Walze usw.) herrühren. An entsprechend hergestellten keramischen Folien wurden auf den Unterseiten, die mit dem Trennmittel in Berührung waren, Rauhigkeitswerte gemessen, die die angegebenen, als vorteilhaft befundenen Werte z.T. erheblich übersteigen. Insbesondere wurden Pₜ-Werte von bis zu 40 µm gefunden. Ferner wurden gefunden, daß die Trennmittelreste inhomogen verteilt sind. Daher zeigten die aufgebrachten, beispielsweise durch Siebdruck erzeugten Funktionsschichten lokal unterschiedliche Merkmale, wie Schichtdicke, Haftvermögen, Konturschärfe, Rißfreiheit, Blasenbildung usw. Dies führt zu einem Ausbeuteverlust, der bis zu 70% der gefertigten Bauteile oder Funktionselemente betragen kann.

Ein absolut gleichmäßiger Auftrag eines Trennmittels, wie Silicon, kann derzeit nur über eine Abscheidung aus der Gasphase (Aufdampfen) erreicht werden. Die bedampfte Kunststoffträgerfolie ist jedoch in der Regel ebenfalls nicht mehrfach verwendbar. Zudem ist die Oberfläche von Siliconbedampften Kunststoffträgerfolien, z.B. aus Polyester, extrem glatt. Es hat sich gezeigt, daß die Unterseiten von entsprechenden getrockneten keramischen Folien Rauhigkeitswerte zeigen, die für eine optimale Haftung der keramischen Schichten zu gering sind; die R_{z}-Werte liegen im Bereich von 0,5-1,0 µm. Auf einer so glatten Oberfläche ist eine für eine gute Schichthaftung hinreichende Verzahnung nicht mehr gewährleistet. Aufgedruckte Schichten können sich bei der weiteren Ver- und Bearbeitung, z. B. beim erneuten Laminieren und bzw. oder Sintern, oder im Dauerbetrieb der letztlich erzeugten Bauteile oder Funktionselemente ablösen. Das ist besonders kritisch, wenn die Funktionselemente Elektroden oder Widerstandsleiterbahnen sind.

Es bestand daher die Aufgabe, einen keramischen, aus mindestens zwei Schichten bestehenden Grünkörper zu einem Verbundkörper mit optimalen Rauhigkeitseigenschaften zusammenzusintern, wobei von einer auf einer geeignet angepaßten Kunststoffträgerfolie aufgebrachten keramischen Substratfolie ausgegangen werden sollte, die sich von dieser wieder problemlos ablösen läßt, ohne daß Reste der Kunststoffträgerfolie das spätere Sinterverfahren beeinträchtigen oder die keramische Substratfolie verformen.

### Vorteile der Erfindung

Nach dem Verfahren der Patentansprüche 1 und 2 hergestellte und im Patentanspruch 3 beanspruchte keramische Verbundkörper vermeiden die geschilderten Nachteile des Standes der Technik. Bauteile und Funktionselemente, die keramische Verbundkörper nach der Erfindung sind oder enthalten, zeichnen sich durch hervorragende Haftung der einzelnen Schichten aufeinander aus. Das gilt auch und besonders für die Haftung der Funktionsschichten, die mit dem Substrat verbunden sind. Die Verbundsysteme sind daher robust und den rauhen Bedingungen gewachsen, wie sie z. B. in Verbrennungsmotoren im Dauerbetrieb herrschen. Auch die mehrschichtigen Grünkörper, die noch Folienbildner bzw. Bindemittel und Weichmacher enthalten, zeigen einen sehr guten Zusammenhalt der Schichten, so daß sie mechanisch stabil und für die weitere Ver- und Bearbeitung gut handhabbar sind. Die einzelnen Schichten sind auch nach dem Cofiring bemerkenswert homogen, zeigen also ein weitgehend konstantes Eigenschaftsbild über die gesamte Schicht, auch wenn die Schichten sehr dünn sind und sich in ihrer Stärke der Größenordnung der Rauhigkeitsmerkmale nähern. Das gilt wiederum auch und besonders für die mit dem Substrat verbundenen Funktionsschichten.

Die keramischen Substratfolien lassen sich nach dem Trocknen leicht von der silanierten Kunststoffträgerfolie ablösen und sind völlig eben und ohne Verwindungskrümmungen. Die Unterseiten der keramischen Substratfolien sind frei von Bestandteilen, die von der Kunstoffträgerfolie abgelöst sein könnten. Überraschenderweise zeigen die silanierten Kunststoffträgerfolien, auch wenn sie Polyesterfolien sind oder eine oberseitig auflaminierte Polyesterfolie enthalten, im Gegensatz zu den bekannten, mit einer aufgebrachten Siliconschicht versehenen Polyesterfolien kein ausgeprägtes elektrostatisches Potential, so daß die Unterseite der keramischen Substratfolie kaum einmal Staubteilchen, Faserteilchen oder ähnliche elektrostatisch von der Kunststoffträgerfolie angezogene und die Oberflächenbeschaffenheit der keramischen Substrafolie störende Partikel aufweist. Die Oberflächenstruktur der Kunststoffträgerfolie, d.h. die Rauhigkeit, und die infolge der Silanierung verminderte Adhäsion der keramischen Substratfolie auf der Kunststoffträgerfolie bleiben auch nach vielen Zyklen praktisch unverändert erhalten.

### Beschreibung der Erfindung

Bei dem Verfahren nach der Erfindung wird zunächst in einem ersten Schritt eine keramische Folie erzeugt, die nach dem Sintern das Substrat ergibt und daher als Substratfolie bezeichnet wird. Dazu geht man von einem keramischen Schlicker aus, der als ersten wesentlichen Bestandteil ein feinteiliges keramisches Rohstoffpulver enthält. Dabei handelt es sich überwiegend um feinteilige, hochschmelzende anorganische oxidische Materialien, nämlich um Oxide, Oxidgemische oder Verbindungen aus anorganischen Oxiden. Als Beispiele seien Aluminiumoxid, Siliciumdioxid, Zirkondioxid, Yttriumstabilisiertes Zirkondioxid, Mischungen aus Aluminiumoxid und Zirkondioxid, Calciumzirkonat (CaZrO₃) und Blei(zirkonat-titanat) (Pb[ZrₓTi₍₁₋ₓ₎]=₃; 0>x>1) genannt. Auch nicht-oxidische hochschmelzende Materialien, wie Carbide, Nitride und Boride eignen sich, allein oder im Gemisch untereinander oder mit oxidischen Materialien, als keramische Rohstoffpulver zur Herstellung des keramischen Schlickers.

Für die Rauhigkeit der keramischen Substratfolie ist die mittlere Teilchengröße (oder Korngröße) der keramischen Rohstoffpulver, d.h. der Durchmesser der Teilchen, sowie die Teilchengrößenverteilung von Bedeutung. Dabei sollte der Anteil der relativ großen Teilchen nicht zu hoch sein. Im allgemeinen liegt der mittlere Teilchendurchmesser zwischen 0,3 µm und 2 µm. Verfahren zur Herstellung derartiger Pulver und zur Messung der genannten Größen sind gut bekannt. Viele geeignete keramische Rohstoffpulver sind im Handel erhältlich.

Ein zweiter wesentlicher Bestandteil des keramischen Schlikkers ist der Folienbildner, d.h. ein organisches Binde- und Plastifiziermittel und gegebenenfalls ein Weichmacher. Das Binde- und Plastifiziermittel sichert den Zusammenhalt der Schichten des Grünkörpers und dessen Handhabbarkeit. Weichmacher erhöhen die Flexibilität der keramischen Substratfolie. Man kann die in der Sintertechnik bekannten Binde- und Plastifiziermittel verwenden, in der Regel also organische Polymerbinder.

Ein gut geeignetes Binde- und Plastifiziermittel ist Polyvinylbutyral. Falls erwünscht, setzt man einen der bekannten niedermolekularen organischen Weichmacher zu, beispielsweise Dioctylphthalat (DOP), Dibutylphthalat (DBP), Dioctyladipat oder (DOA). Der dritte wesentliche Bestandteil des keramischen Schlickers ist ein Lösungsmittel, das mit dem Binde- und Plastifiziermittel verträglich ist und dem keramischen Schlicker die für die Verarbeitung, z.B. durch Gießen, erforderliche Konsistenz verleiht. Geeignete Lösungsmittel sind z.B. niedermolekulare organische Lösungsmittel, wie Ethanol, Aceton, Methylethylketon, Cyclohexanol, Butanol, Butylacetat oder Toluol. Natürlich kann man auch mit Lösungsmittelgemischen arbeiten, z.B. mit Ethanol/Toluol-Gemischen. Auch Wasser kann in Verbindung mit hydrophilen Binde- und Plastifiziermitteln als Lösungsmittel dienen, z.B. zusammen mit Polyvinylalkohol oder Polyvinylacrylat und Glycerin.

Die optimale Menge eines gegebenen Binde- und Plastifiziermittels hängt u.a. von derArt und der Feinheit des keramischen Rohstoffpulvers ab. Sie beträgt im allgemeinen 5 bis 15 Gewichtsprozent, bezogen auf das keramische Rohstoffpulver. Die Menge des Lösungsmittels richtet sich hauptsächlich nach der für die Verarbeitung erforderlichen Konsistenz des keramischen Schlickers. Sie liegt für Gießverfahren im allgemeinen bei 15 bis 40 Gewichtsprozent, bezogen auf den keramischen Schlicker.

Die keramischen Schlicker werden durch Zusammenmischen der Bestandteile in beliebiger Reihenfolge erhalten. Mischen unter größerer Scherkraft, z.B. in einer Kugelmühle, auf einem Walzenstuhl oder in einer Vibrationsmühle, fördert die Benetzung und gleichmäßige Dispergierung der Pulverteilchen.

Keramische Schlicker der beschriebenen Art und insbesondere mit den angegebenen Korngrößen und Korngrößenverteilungen ergeben im allgemeinen bei der Verarbeitung keramische Substratfolien, deren Oberseite die zuvor erwähnten, als vorteilhaft befundenen Rauhigkeitswerte zeigen. Die Rauhigkeit der Unterseite wird zudem durch die Rauhigkeit und sonstigen Eigenschaften der Kunststoffträgerfolie bestimmt, wie im folgenden erläutert wird. Der keramische Schlicker wird als Schicht auf eine Kunststoffträgerfolie aufgebracht, vorteilhaft durch Gießen, z.B. nach dem erwähnten Doctorblade-Verfahren. Die Stärke der Schicht variiert, je nach dem späteren Verwendungszweck. Für die Herstellung der erwähnten Sensorelemete zur Messung der Sauerstoffkonzentration in Gasen beträgt die Schichtdicke im allgemeinen 0,2 bis 0,8 µm.

Die Oberfläche der Kunststoffträgerfolie weist eine Rauhigkeit auf, die der gewünschten Rauhigkeit der Unterseite der keramischen Substratfolien entspricht, und ist silaniert. Für das Verfahren der Erfindung eignen sich Folien aus allen bekannten folienbildenden Kunststoffen, deren Oberflächen silanierbar sind. So lassen sich beispielsweise Folien aus Polyethylen, Polypropylen, Polyestern, Polyamiden, Polyurethanen usw. verwenden. Auch Verbundfolien mit einer Grundfolie und auflaminierter Deckfolie können eingesetzt werden, beispielsweise Folien mit einer Polyethylengrundfolie und einer auflaminierten Polyesterfolie. Die Kunststoffträgerfolien müssen hinreichend stark sein, damit ein verwindungsfreies Trocknen der Schlickerschicht zur keramischen Substratfolie möglich ist. Dieses Erfordernis wird für die Kunststoffträgerfolien nach der Erfindung leichter als bei den mit Siliconöl beschichteten Folien des Standes der Technik erfüllt, weil infolge der Silanierung die Adhäsionskräfte zwischen dem keramischem Schlicker und insbesondere dem darin enthaltenen Folienbildner einerseits und dem Kunststoff andererseits geringer sind. In der Regel sind die Kunststoffträgerfolien zwischen 50 µm und 250 µm stark.

Wenn die Kunststoffträgerfolie eine Gießfolie ist, läßt sich durch Wahl einer geeigneten metallischen Gießfläche sicherstellen, daß die gegossene Folie auf ihrer Unterseite eine der gewünschten Rauhigkeit der Unterseite der keramischen Substratfolie entsprechende Rauhigkeit aufweist. Extrudierten Folien läßt sich die gewünschte Rauhigkeit aufprägen, indem man sie bei einer Temperatur nahe der Erweichungstemperatur unter einem bestimmten Andruck über Metallwalzen mit einer entsprechenden Rauhigkeit laufen läßt. Nicht selten erfüllen auch im Handel erhältliche Kunststoffolien die geforderten Rauhigkeitsbedingungen, so daß es nur einer Auswahl bedarf.

Durch die Silanierung werden Siliciumverbindungen offenbar chemisch auf der Oberfläche der Kunststoffträgerfolie gebunden. Jedenfalls lassen sich durch Lösungsmittel ebensowenig wie durch die keramischen Schlicker merkliche Mengen an Siliciumverbindungen von der Kunststoffträgerfolie ablösen. Auch der Umstand, daß die adhäsionsmindernde Wirkung der Silanierung selbst nach vielen Zyklen praktisch unverändert erhalten bleibt, spricht für eine chemische Bindung der Siliciumverbindungen auf der Oberfläche der Kunststoffträgerfolie.

Silanierbar ist eine Kunststoffträgerfolie, wenn sie auf ihrer Oberfläche funktionale Gruppen enthält, die mit geeigneten funktionalen Gruppen von Siliciumverbindungen, zweckmäßig Silanen oder niedermolekularen Siloxanen, zu reagieren vermögen. Beispielsweise lassen sich die Oberflächen von Polyesterfolien, beispielsweise aus Polyethylenterephthalat, auf denen sich Hydroxylgruppen insbesondere dann finden, wenn mit einem stöchiometrischen Überschuß an Ethylenglykol gearbeitet wurde, mit Organylhalogensilanen, insbesondere Alkylchlorsilanen, oder mit Organylacyloxysilanen, insbesondere Alkylacetoxysilanen, behandeln, wobei die Siliciumverbindungen fixiert werden, wohl unter Ausbildung von Si-O-C-Verknüpfungen. Die Behandlung kann durch Bedampfen der Kunststoffträgerfolie mit entsprechenden Siliciumverbindungen geschehen. Alternativ kann die Kunststoffträgerfolie auch mit einer Lösung der Siliciumverbindung behandelt werden, wobei zweckmäßig ein tertiäres Amin, wie Pyridin oder Triethylamin, zugesetzt wird, um die entstehenden Nebenprodukte Halogenwasserstoff und Carbonsäure abzufangen. Wenn man die Oberfläche von Polyurethanfolien, die inbesondere bei einem stöchiometrischen Überschuß an Diisocyanat Isocyanatgruppen aufweist, mit Organylaminosilanen, insbesondere Alkylaminosilanen, behandelt, wird wiederum die Siliciumverbindung fixiert, wohl unter Ausbildung einer verknüpfenden Harnstoffstruktur. Silanierte Kunststoffträgerfolien sind im Handel erhältlich.

Die silanierten Kunststoffträgerfolien können, ebenso wie die mit Siliconöl beschichteten Folien des Standes der Technik, in kontinuierlich arbeitenden Anlagen von einem Stahlband mitgeführt werden. Nach dem Auftragen des keramischen Schlickers als Schicht auf die Kunststoffträgerfolie wird Lösungsmittel entfernt, zweckmäßig durch Trocknen mit einem auf 70 bis 150°C erwärmtem Luftstrom und/oder durch IR-Bestrahlung. Die so entstehenden keramischen Substratfolien lassen sich problemlos von der Kunststoffträgerfolie ablösen, wenn der das Lösungsmittel zumindest weitgehend verdampft ist. Aus den keramischen Substratfolien lassen sich Substratkarten ausstanzen, die weiter beschichtet werden können.

In einem weiteren Verfahrensschritt wird zumindest auf die Unterseite der keramischen Substratfolie oder daraus ausgestanzter Substratkarten, die mit der Kunststoffträgerfolie in Berührung war, eine Schicht aus einem zweiten, zumindest hinsichtlich des keramischen Rohstoffpulvers anders zusammengesetzte Schlicker aufgebracht, aus der nach dem Cofiring eine Funktionsschicht entsteht. Dies geschieht zweckmäßig in einem Dickschichtverfahren, insbesondere durch Siebdruck in an sich bekannter Weise. Die Wahl des keramischen Rohstoffpulvers für den zweiten Schlicker richtet sich nach der vorgesehenen Funktion der späteren Funktionsschicht. Im übrigen gelten hinsichtlich der Teilchengrößen und ihrer Verteilung, des Folienbildners und des Lösungsmittels mutatis mutandis die Erläuterungen im Zusammenhang mit der Herstellung der keramischen Substratfolie, ebenso wie für das anschließende Verdampfen des Lösungsmittels.

Der so erhaltene Grünkörper kann dann zu einem gesinterten Verbundkörper weiterverarbeitet werden. Wenn die spätere Verwendung weitere Funktionsschichten erfordert, werden jedoch zweckmäßig zuvor Schichten aus entsprechenden Schlikkern auf die Oberseite der keramischen Substratfolien oder -karten und/oder der ersten Funktionsschicht(en) aufgebracht; die Erläuterungen hinsichtlich der ersten Funktionsschicht gelten entsprechend.

Aus dem endgültigen Grünkörper werden organische Anteile, d.h. Binde- und Plastifiziermittel sowie gegebenenfalls Weichmacher und Lösungsmittelreste, in bekannter Weise durch Erhitzen entfernt. Dies geschieht zweckmäßig unter Luftzutritt, beispielsweise in einem Umluftofen, um den oxidativen Abbau der organischen Anteile zu fördern. Danach folgt der an sich ebenfalls gut bekannte Sinterschritt. Die Sintertemperatur und die Dauer des Sinterns richten sich wie üblich nach der Art der keramischen Rohstoffpulver.

Die keramischen Verbundkörper nach der Erfindung zeigen einen durchgehend stoffschlüssigen Verbund von Funktionsschichten und Substrat. Bei keramographischen Gefügeuntersuchungen sind die Fügestellen der Schichten nicht mehr zu lokalisieren. Die Verbundkörper sind als elektrische oder elektronische Bauteile oder Funktionselemente, wie zuvor erläutert, oder als Bestandteile solcher Bauteile oder Funktionselemente geeignet.

## Patentansprüche

1. Verfahren zur Herstellung von keramischen, aus mindestens zwei Schichten bestehenden Verbundkörpern, wobei (1) eine keramische Substratfolie, bestehend aus einem Schlikker, der feinteilige keramische Rohstoffpulver, einen organischen Folienbildner und ein Lösungsmittel enthält, auf eine Kunststoffträgerfolie aufgebracht wird, das Lösungsmittel verdampft und die keramische Folie von der Kunststoffträgerfolie abgelöst wird, (2) zumindest auf diejenige Seite der keramischen Substratfolie oder einer daraus ausgestanzten Substratkarte, die mit der Kunststoffträgerfolie in Berührung war, eine Schicht aus einem zweiten, zumindest hinsichtlich des feinteiligen keramischen Rohstoffpulvers anders zusammengesetzten keramischen Schlicker aufbringt und das Lösungsmittel verdampft und (3) den entstandenen, aus zumindest zwei Schichten bestehenden Grünkörper zur Entfernung von organischen Bestandteilen erhitzt und die Schichten zu einem Verbundkörper zusammensintert, **dadurch gekennzeichnet**, daß die keramische Substratfolie eine gemittelte Rauhtiefe (R_{z}) im Bereich von 2 bis 10 µm, eine maximale Rauhtiefe (Rₐ) < 10 µm und eine Profiltiefe (Pₜ) < 10 µm aufweist und daß die Oberfläche der Kunststoffträgerfolie eine den Rauhigkeitseigenschaften der keramischen Substratfolie entsprechende Rauhigkeit aufweist und silaniert ist.

2. Verfahren nach Anspruch 1, **dadurch gekennzeichnet**, daß die Kunststoffträgerfolie aus einem oberflächlich silanierten Polyester besteht oder zumindest eine silanierte Polyesteroberfläche aufweist.

3. Verbundsysteme mit mindestens zwei durch Sintern miteinander verbundenen Schichten, wobei die Verbundsysteme elektrische oder elektronische Bauteile oder Funktionselemente oder Bestandteile solcher Bauteile oder Funktionselemente sind, **dadurch gekennzeichnet**, daß die durch Sintern verbundenen Schichten nach dem Verfahren der Ansprüche 1 oder 2 hergestellt wurden.

## Claims

1. Process for producing ceramic composites consisting of at least two layers, where (1) a ceramic substrate film consisting of a slip comprising finely divided ceramic raw material powders, an organic film former and a solvent is applied to a plastic support film, the solvent is evaporated and the ceramic film is detached from the plastic support film, (2) a layer comprising a second ceramic slip having a different composition at least in respect of the finely divided ceramic raw material powder is applied to at least that side of the ceramic substrate film or a substrate card stamped therefrom and the solvent is evaporated and (3) the resulting green body consisting of at least two layers is heated to remove organic constituents and the layers are sintered together to form a composite, characterized in that the ceramic substrate film has a mean peak-to-valley height (R_{z}) in the range from 2 to 10 µm, a maximum peak-to-valley height (Rₐ) of < 10 µm and a profile depth (Pₜ) of < 10 µm and in that the surface of the plastic support film has a roughness corresponding to the roughness properties of the ceramic substrate film and is silanated.

2. Process according to Claim 1, characterized in that the plastic support film consists of a surface-silanated polyester or at least has a silanated polyester surface.

3. Composite systems having at least two layers adjoined to one another by sintering, where the composite systems are electrical or electronic components or functional elements or constituents of such components or functional elements, characterized in that the layers joined by sintering have been produced by the process of Claim 1 or 2.

## Revendications

1. Procédé de fabrication de corps composites céramiques constitués d'au moins deux couches, dans lequel (1) on dépose sur une feuille support de matière plastique une feuille substrat de céramique, constituée d'une barbotine qui contient une poudre brute de céramique fine, un liant de feuille organique et un solvant, on fait évaporer le solvant et on détache la feuille céramique de la feuille support en matière plastique, (2) on dépose au moins sur le côté de la feuille substrat de céramique ou d'une carte substrat découpée dans cette feuille qui était en contact avec la feuille support en matière plastique , une couche d'une seconde barbotine de céramique de composition différente, au moins en ce qui.concerne la poudre brute de céramique fine, et on fait évaporer le solvant, et (3) on chauffe l'ébauche apparue, constituée d'au moins deux couches, pour éliminer les composants organiques, et on fritte ensemble les couches en un composite,
caractérisé en ce que
• la feuille substrat de céramique présente une profondeur d'aspérité moyenne (R_{z}) comprise entre 2 et 10 µm, une profondeur d'aspérité maximale (Rₐ) < 10 µm et une profondeur de profil (Pₜ) < 10 µm, et
• la surface de la feuille support de matière plastique présente une rugosité correspondant aux propriétés de rugosité de la feuille substrat de céramique et est silanisée.

2. Procédé selon la revendication 1,
caractérisé en ce que
la feuille support de matière plastique se compose d'un polyester superficiellement silanisé ou présente au moins une surface de polyester silanisée.

3. Systèmes composites avec au moins deux couches reliées entre elles par frittage, les systèmes composites étant des composants ou éléments fonctionnels électriques ou électroniques ou des constituants de tels composants ou éléments de fonction,
caractérisés en ce que
les couches réunies par frittage ont été fabriquées selon le procédé des revendications 1 ou 2.
